# EUROPEAN PATENT APPLICATION

(11) **EP 4 852 642 A1**
(43) Date of publication of application: **09.12.2026**
(21) Application number: 26169627.2
(22) Date of filing: 31.03.2026
(51) Int. Cl.: H10B 10/00, G11C 11/412, G11C 5/02, H10D 30/67, H10D 62/80, H10D 88/00

(54) **STATIC RANDOM-ACCESS MEMORY DEVICE HAVING MONOLITHIC 3D STACK STRUCTURE AND ELECTRONIC APPARATUS INCLUDING THE STATIC RANDOM-ACCESS MEMORY DEVICE**

(30) Priority: 02.06.2025 KR 20250072413
(71) Applicant: Samsung Electronics Co., Ltd., Suwon-si, Gyeonggi-do 16677 (KR)
(72) Inventor: Kim, Sangwon, 16678 Suwon-si, Gyeonggi-do (KR); Shim, Jaewoo, 16678 Suwon-si, Gyeonggi-do (KR); Hu, Luhing, 16678 Suwon-si, Gyeonggi-do (KR); Kim, Joonyun, 16678 Suwon-si, Gyeonggi-do (KR); Jang, Hyeongseok, 16678 Suwon-si, Gyeonggi-do (KR)
(74) Representative: Grünecker Patent- und Rechtsanwälte PartG mbB

(57) **Abstract**

Provided are a static random-access memory (SRAM) device having a monolithic 3D stack structure, and an electronic apparatus including the SRAM device. The SRAM device includes a first tier including a first transistor and a second transistor, a second tier on the first tier and including a third transistor and a fourth transistor, and a third tier on the second tier and including a fifth transistor and a sixth transistor. Each of the first to sixth transistors includes a channel layer including a 2D semiconductor material. The third transistor shares a gate of the first transistor, and the fourth transistor shares a gate of the second transistor. A gate of the fifth transistor crosses the gate of the first transistor, and a gate of the sixth transistor crosses the gate of the second transistor.

## Description

### BACKGROUND

### 1. Field

Some example embodiments of the disclosure relate to static random-access memory (SRAM) devices having a monolithic 3D stack structure and/or electronic apparatuses including the SRAM device.

### 2. Description of the Related Art

Recently, down-scaling of semiconductor devices has rapidly progressed. In addition, as semiconductor devices desire not only higher operation speed but also more accuracy in operation, the structure of transistors included in semiconductor devices has been further optimized or reduced. Static random-access memory (SRAM) devices are semiconductor components that occupy a significant portion of a central processing unit (CPU). Thus, it is desired to improve the integration density of SRAM devices for more efficient memory-CPU communication.

### SUMMARY

Some example embodiments provide static random-access memory (SRAM) devices having a monolithic 3D stack structure and/or electronic apparatuses including the SRAM device.

The invention is what is claimed in the independent claims. Preferred embodiments are specified in the dependent claims.

Additional aspects will be set forth in part in the description which follows and, in part, will be apparent from the description, or may be learned by practice of the presented example embodiments of the disclosure.

According to an example embodiment of the disclosure, a static random-access memory (SRAM) device may include a first tier comprising a first transistor and a second transistor, a second tier on the first tier, the second tier comprising a third transistor and a fourth transistor, and a third tier on the second tier, the third tier comprising a fifth transistor and a sixth transistor, wherein each of the first to sixth transistors comprises a channel layer comprising a 2D semiconductor material, the third transistor shares a gate of the first transistor, the fourth transistor shares a gate of the second transistor, a gate of the fifth transistor crosses the gate of the first transistor, and a gate of the sixth transistor crosses the gate of the second transistor.

The first and second transistors may share a first common source, and a supply voltage line may be in a lower portion of the first tier and may be connected to the first common source.

The third and fourth transistors may share a second common source, and a ground voltage line may be in an upper portion of the second tier and connected to the second common source.

A word line may be in an upper portion of the third tier and may be connected to the gates of the fifth and sixth transistors.

The supply voltage line, the ground voltage line, and the word line may overlap each other in a plan view.

A drain of the first transistor, the gate of the second transistor, a drain of the third transistor, and a drain of the fifth transistor may be electrically connected to each other through a first metal line.

A drain of the second transistor, the gate of the first transistor, a drain of the fourth transistor, and a drain of the sixth transistor may be electrically connected to each other through a second metal line.

Each of the first and second transistors may include a p-channel metal-oxide-semiconductor (PMOS) field-effect transistor (FET), and each of the third, fourth, fifth, and sixth transistors may include an n-channel metal-oxide-semiconductor (NMOS) FET.

The first and third transistors may configure a first complementary metal-oxide-semiconductor (CMOS) inverter, and the second and fourth transistors may configure a second CMOS inverter.

Each of the fifth and sixth transistors may include an access transistor.

According to an example embodiment of the disclosure, a static random-access memory (SRAM) device includes a first tier comprising a first transistor and a second transistor, a second tier on the first tier, the second tier comprising a third transistor and a fourth transistor, and a third tier on the second tier, the third tier comprising a fifth transistor and a sixth transistor, wherein each of the first to sixth transistors comprises a channel layer comprising a 2D semiconductor material, the fifth transistor shares a gate of the third transistor, the sixth transistor shares a gate of the fourth transistor, a gate of the first transistor crosses the gate of the third transistor, and a gate of the second transistor crosses the gate of the fourth transistor.

A word line may be in a lower portion of the first tier and may be connected to the gate of the first transistor and the gate of the second transistor.

The third and fourth transistors may share a first common source, and a ground voltage line may be in a lower portion of the second tier and may be connected to the first common source.

The fifth and sixth transistors may share a second common source, and a supply voltage line may be in an upper portion of the third tier and may be connected to the second common source.

The word line, the ground voltage line, and the supply voltage line may overlap each other in a plan view.

A drain of the first transistor, a drain of the third transistor, the gate of the fourth transistor, and a drain of the fifth transistor may be electrically connected to each other through a first metal line.

A drain of the second transistor, the gate of the third transistor, a drain of the fourth transistor, and a drain of the sixth transistor may be electrically connected to each other through a second metal line.

Each of the first, second, third, and fourth transistors may include an n-channel metal-oxide-semiconductor (NMOS) field-effect transistor (FET), and each of the fifth and sixth transistors may include a p-channel metal-oxide-semiconductor (PMOS) FET.

According to an example embodiment of the disclosure, an electronic apparatus includes a static random-access memory (SRAM) device, wherein the SRAM device includes a first tier comprising a first transistor and a second transistor, a second tier on the first tier, the second tier comprising a third transistor and a fourth transistor, and a third tier on the second tier, the third tier comprising a fifth transistor and a sixth transistor, and wherein each of the first to sixth transistors comprises a channel layer comprising a 2D semiconductor material, the third transistor shares a gate of the first transistor, the fourth transistor shares a gate of the second transistor, and a gate of the fifth transistor crosses the gate of the first transistor, and a gate of the sixth transistor crosses the gate of the second transistor.

A supply voltage line in the first tier, a ground voltage line in the second tier, and a word line in the third tier may overlap each other in a plan view.

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1 is a circuit diagram schematically illustrating a static random-access memory (SRAM) device according to an example embodiment;
FIG. 2 is a cross-sectional view schematically illustrating an SRAM device according to an example embodiment;
FIG. 3 is a plan view illustrating of FIG. 3 SRAM device according to an example embodiment;
FIG. 4A is a plan view illustrating a first tier in the SRAM device according to an example embodiment;
FIG. 4B is a plan view illustrating a second tier in the SRAM device of FIG. 3 according to an example embodiment;
FIG. 4C is a plan view illustrating a third tier in the SRAM device of FIG. 3 according to an example embodiment;
FIG. 5A is a cross-sectional view taken along line I-I' of FIG. 3;
FIG. 5B is a cross-sectional view taken along line II-II' of FIG. 3;
FIG. 6 is a view schematically illustrating a circuit configuration of an SRAM device according to an example embodiment;
FIG. 7 is a plan view illustrating an SRAM device according to another example embodiment;
FIG. 8A is a plan view illustrating a first tier in the SRAM device of FIG. 7 according to an example embodiment;
FIG. 8B is a plan view illustrating a second tier in the SRAM device of FIG. 7 according to an example embodiment;
FIG. 8C is a plan view illustrating a third tier in the SRAM device of FIG. 7 according to an example embodiment;
FIG. 9A is a cross-sectional view taken along line I-I' of FIG. 7;
FIG. 9B is a cross-sectional view taken along line II-II' of FIG. 7;
FIG. 10 is a view schematically illustrating a circuit configuration of the SRAM device of FIG. 7 (as well as FIGS. 8A-9B) according to an example embodiment; and
FIG. 11 is a conceptual view schematically illustrating a device architecture applicable to an electronic apparatus according to an example embodiment.

### DETAILED DESCRIPTION

Reference will now be made in detail to example embodiments, examples of which are illustrated in the accompanying drawings. In this regard, the present example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," "one of," "one or more of," "any one of," and "at least one selected from" when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of example embodiments.

Hereinafter, some example embodiments will be described with reference to the accompanying drawings. In the drawings, like reference numerals refer to like elements, and the sizes of elements may be exaggerated for clarity of illustration. The example embodiments described herein are for illustrative purposes only, and various modifications may be made therein.

In the following description, when an element is referred to as being "above" or "on" another element, it may be directly on an upper, lower, left, or right side of the other element while making contact with the other element or may be above an upper, lower, left, or right side of the other element without making contact with the other element. The terms of a singular form may include plural forms unless otherwise mentioned. It will be further understood that the terms "comprises" and/or "comprising" used herein specify the presence of stated features or elements, but do not preclude the presence or addition of one or more other features or elements.

An element referred to with the definite article or a demonstrative determiner may be construed as the element or the elements even though it has a singular form. Operations of a method may be performed in an appropriate order unless explicitly described in terms of order or described to the contrary, and are not limited to the stated order thereof.

In the disclosure, terms such as "unit" or "module" may be used to denote a unit that has at least one function or operation and is implemented with hardware, software, or a combination of hardware and software.

Furthermore, line connections or connection members between elements depicted in the drawings represent functional connections and/or physical or circuit connections by way of example, and in actual applications, they may be replaced or embodied with various additional functional connections, physical connections, or circuit connections.

Examples or terms are just used herein to describe technical ideas and should not be considered for purposes of limitation unless defined by the claims.

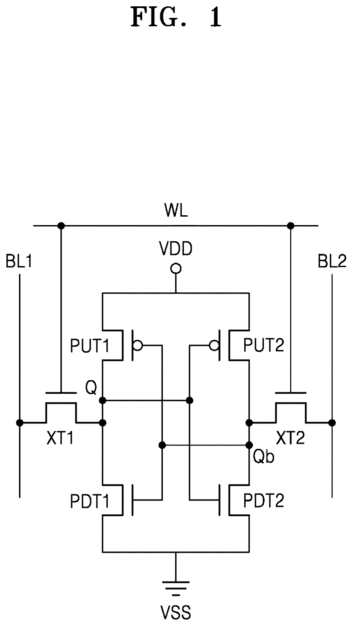

FIG. 1 is a circuit diagram view schematically illustrating a static random-access memory (SRAM) device 100 according to an example embodiment. FIG. 1 is a circuit diagram illustrating one memory cell among a plurality of memory cells of the SRAM device 100.

Referring to FIG. 1, according to an example embodiment, each of the memory cells of the SRAM device 100 may include six transistors. For example, each of the memory cells of the SRAM device 100 may include a first access transistor XT1, a second access transistor XT2, a first pull-up transistor PUT1, a second pull-up transistor PUT2, a first pull-down transistor PDT1, and a second pull-down transistor PDT2.

The first pull-up transistor PUT1 and the second pull-up transistor PUT2 may be p-channel metal oxide semiconductor (PMOS) field-effect transistors (FETs), the first pull-down transistor PDT1 and the second pull-down transistor PDT2 may be n-channel metal oxide semiconductor (NMOS) FETs, and the first access transistor XT1 and the second access transistor XT2 may be NMOS FETs. The first pull-up transistor PUT1 and the first pull-down transistor PDT1 may form a complementary metal-oxide-semiconductor (CMOS) inverter and may serve as a storage element. In addition, the second pull-up transistor PUT2 and the second pull-down transistor PDT2 may form a CMOS inverter and may serve as a storage element. Supply voltage VDD may be connected to the first and second pull-up transistors PUT1 and PUT2, and ground voltage VSS may be connected to the first and second pull-down transistors PDT1 and PDT2.

The first and second access transistors XT1 and XT2 may function to allow access to the CMOS inverters (storage elements) during data read and write operations, and to block access during data hold periods. A first bit line BL1 may be connected to a source of the first access transistor XT1, and a drain of the first access transistor XT1 may be connected to a gate of the second pull-up transistor PUT2 and a gate of the second pull-down transistor PDT2 through a first node Q. In addition, a second bit line BL2 may be connected to a source of the second access transistor XT2, and a drain of the second access transistor XT2 may be connected to a gate of the first pull-up transistor PUT1 and a gate of the first pull-down transistor PDT1 through a second node Qb. A word line WL may be connected to gates of the first and second access transistors XT1 and XT2.

As described below, according to an example embodiment, the SRAM device 100 may have a monolithic 3D stack structure by disposing, in different tiers, the first and second pull-up transistors PUT1 and PUT2, the first and second pull-down transistors PDT1 and PDT2, and the first and second access transistors XT1 and XT2.

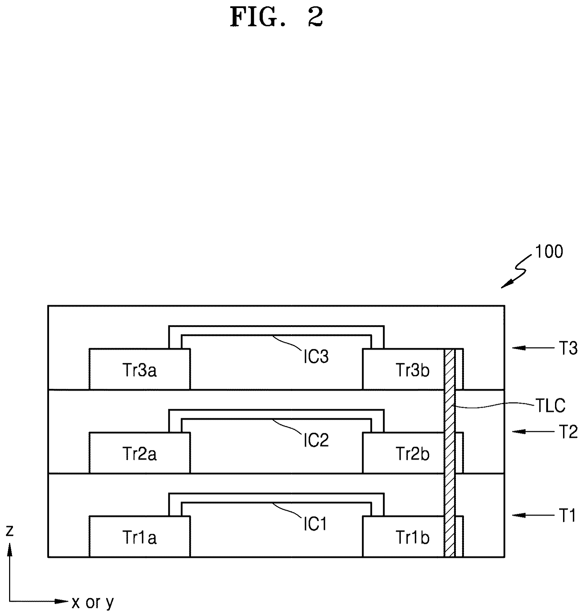

FIG. 2 is a cross-sectional view schematically illustrating the SRAM device 100 according to an example embodiment. FIG. 2 is a cross-sectional view illustrating one memory cell among the memory cells of the SRAM device 100.

Referring to FIG. 2, each of the memory cells of the SRAM device 100 may have a monolithic 3D stack structure formed by stacking three tiers T1, T2, and T3. Each of the memory cells of the SRAM device 100 may include three tiers stacked in a vertical direction (z-axis direction), that is, first, second, and third tiers T1, T2, and T3. Here, the first, second, and third tiers T1, T2, and T3 may include pairs of transistors Tr1a and Tr1b, Tr2a and Tr2b, and Tr3a and Tr3b, respectively.

For example, the first tier T1 may include a pair of transistors, that is, a first transistor Tr1a and a second transistor Tr1b. The first and second transistors Tr1a and Tr1b may be arranged in a horizontal direction (x-axis direction or y-axis direction). In the first tier T1, the first and second transistors Tr1a and Tr1b may be electrically connected to each other through a first interconnect IC1. Each of the first and second transistors Tr1a and Tr1b may be, for example, a PMOS FET. For example, the first transistor Tr1a may be the first pull-up transistor PUT1 (refer to FIG. 1), and the second transistor Tr1b may be the second pull-up transistor PUT2 (refer to FIG. 1).

The second tier T2 may be disposed above the first tier T1. The second tier T2 may include a pair of transistors, that is, a third transistor Tr2a and a fourth transistor Tr2b. The third and fourth transistors Tr2a and Tr2b may be arranged in a horizontal direction (x-axis direction or y-axis direction). Here, the third and fourth transistors Tr2a and Tr2b may be arranged in parallel with the first and second transistors Tr1a and Tr1b. However, example embodiments are not limited thereto, and the third and fourth transistors Tr2a and Tr2b may be arranged perpendicularly to the first and second transistors Tr1a and Tr1b. In the second tier T2, the third and fourth transistors Tr2a and Tr2b may be electrically connected to each other through a second interconnect IC2. Each of the third and fourth transistors Tr2a and Tr2b may be, for example, an NMOS FET. For example, the third transistor Tr2a may be the first pull-down transistor PDT1 (refer to FIG. 1), and the fourth transistor Tr2b may be the second pull-down transistor PDT2 (refer to FIG. 1).

The third tier T3 is disposed above the second tier T2. The third tier T3 may include a pair of transistors, that is, a fifth transistor Tr3a and a sixth transistor Tr3b. The fifth and sixth transistors Tr3a and Tr3b may be arranged in a horizontal direction (x-axis direction or y-axis direction). Here, the fifth and sixth transistors Tr3a and Tr3b may be arranged perpendicularly to the third and fourth transistors Tr2a and Tr2b. However, example embodiments are not limited thereto, and the fifth and sixth transistors Tr3a and Tr3b may be arranged in parallel with the third and fourth transistors Tr2a and Tr2b. In the third tier T3, the fifth and sixth transistors Tr3a and Tr3b may be electrically connected to each other through a third interconnect IC3. Each of the fifth and sixth transistors Tr3a and Tr3b may be, for example, an NMOS FET. For example, the fifth transistor Tr3a may be the first access transistor XT1 (refer to FIG. 1), and the sixth transistor Tr3b may be the second access transistor XT2 (refer to FIG. 1).

Each of the first to sixth transistors Tr1a, Tr1b, Tr2a, Tr2b, Tr3a, and Tr3b may include a channel layer including a 2D semiconductor material. Here, the 2D semiconductor material refers to a semiconductor material having a layered structure in which constituent atoms are two-dimensionally bonded to each other. The 2D semiconductor material may include, for example, a transition metal dichalcogenide (TMD). However, example embodiments are not limited thereto. TMD is a 2D material having semiconductor properties and is a compound of transition metal and a chalcogen element. Here, the transition metal may include at least one selected from Mo, W, Nb, V, Ta, Ti, Zr, Hf, Co, Tc, or Re, and the chalcogen element may include at least one selected from S, Se, or Te. Examples of the TMD may include MoS₂, MoSe₂, MoTe₂, WS₂, WSe₂, WTe₂, ZrS₂, ZrSe₂, HfS₂, HfSe₂, NbSe₂, ReSe₂, and the like.

When the first and second transistors Tr1a and Tr1b disposed in the first tier T1 are PMOS FETs, each of the channel layers of the first and second transistors Tr1a and Tr1b may include, for example, a p-type 2D semiconductor material (e.g., WSe₂ or the like). However, example embodiments are not limited thereto, and each of the channel layers of the first and second transistors Tr1a and Tr1b may include a 2D semiconductor material doped with a p-type dopant.

When the third and fourth transistors Tr2a and Tr2b disposed in the second tier T2 are NMOS FETs, each of the channel layers of the third and fourth transistors Tr2a and Tr2b may include, for example, an n-type 2D semiconductor material (e.g., MoS₂ or the like). However, example embodiments are not limited thereto, and each of the channel layers of the third and fourth transistors Tr2a and Tr2b may include a 2D semiconductor material doped with an n-type dopant.

When the fifth and sixth transistors Tr3a and Tr3b disposed in the third tier T3 are NMOS FETs, each of the channel layers of the fifth and sixth transistors Tr3a and Tr3b may include, for example, an n-type 2D semiconductor material (e.g., MoS₂ or the like). However, example embodiments are not limited thereto, and each of the channel layers of the fifth and sixth transistors Tr3a and Tr3b may include a 2D semiconductor material doped with an n-type dopant.

Inside the first, second, and third tiers T1, T2, and T3, at least one inter-floor connection layer TLC may be provided to electrically connect transistors disposed in different tiers to each other. For example, one of the first and second transistors Tr1a and Tr1b disposed in the first tier T1, one of the third and fourth transistors Tr2a and Tr2b disposed in the second tier T2, and one of the fifth and sixth transistors Tr3a and Tr3b disposed in the third tier T3 may be electrically connected to each other through the at least one inter-floor connection layer TLC. Here, the at least one inter-floor connection layer TLC may be formed by conductive members such as metal lines, source/drains, gates, or gate contacts, which are electrically connected to each other.

The description above discusses an example in which the first and second transistors Tr1a and Tr1b disposed in the first tier T1 are PMOS FETs, the third and fourth transistors Tr2a and Tr2b disposed in the second tier T2 are NMOS FETs, and the fifth and sixth transistors Tr3a and Tr3b disposed in the third tier T3 are NMOS FETs. However, this is only an example, and the pair of transistors disposed in each of the first, second, and third tiers T1, T2, and T3, that is, the first and second transistors Tr1a and Tr1b, the third and fourth transistors Tr2a and Tr2b, or the fifth and sixth transistors Tr3a and Tr3b, may be PMOS FETs or NMOS FETs as desired.

In addition, the description above discusses an example in which each of the memory cells of the SRAM device 100 includes a total of six transistors, that is, the first to sixth transistors Tr1a, Tr1b, Tr2a, Tr2b, Tr3a, and Tr3b. However, example embodiments are not limited thereto, and each of the memory cells may include more than six transistors (e.g., eight transistors) to improve the performance of the SRAM device 100 or to operate as a computing unit. In this case, each of the memory cells may include more than three tiers (e.g., four tiers that are vertically stacked).

Hereinafter, the first, second, and third tiers T1, T2, and T3 of each of the memory cells of the SRAM device 100 will be further described with reference to planar layouts and cross-sectional views according to some example embodiments. For example, the first and second transistors Tr1a and Tr1b disposed in the first tier T1 may be PMOS FETs, the third and fourth transistors Tr2a and Tr2b disposed in the second tier T2 may be NMOS FETs, and the fifth and sixth transistors Tr3a and Tr3b disposed in the third tier T3 may be NMOS FETs.

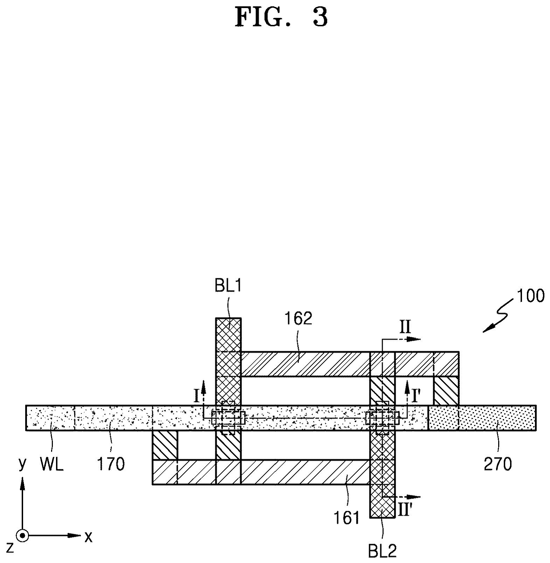

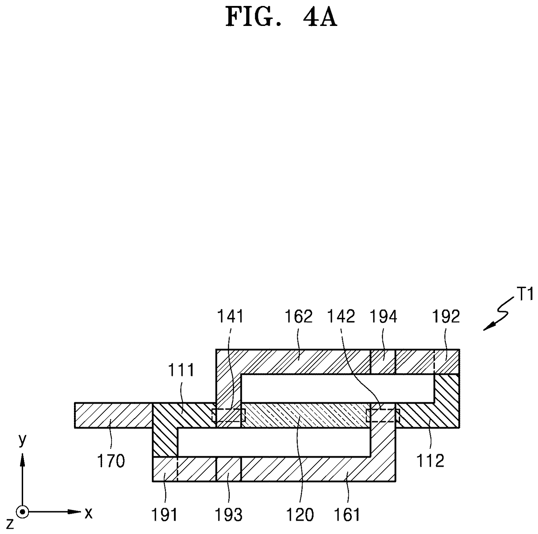

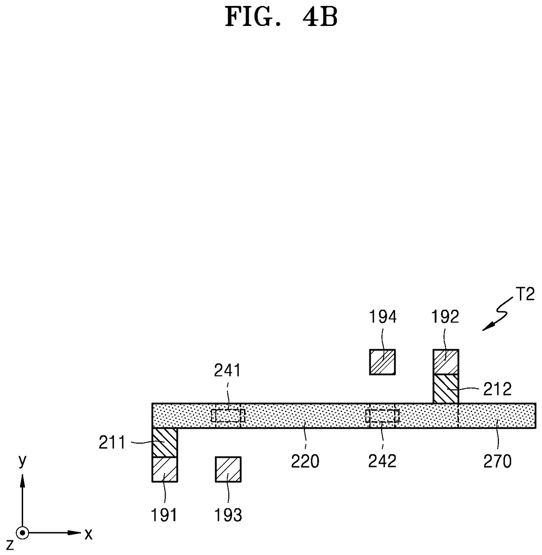

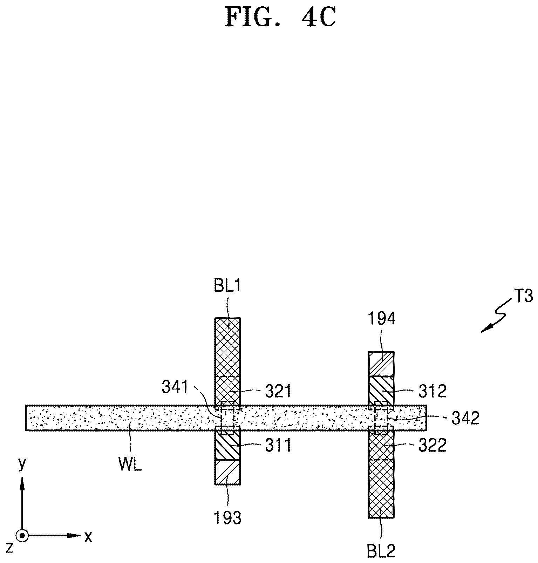

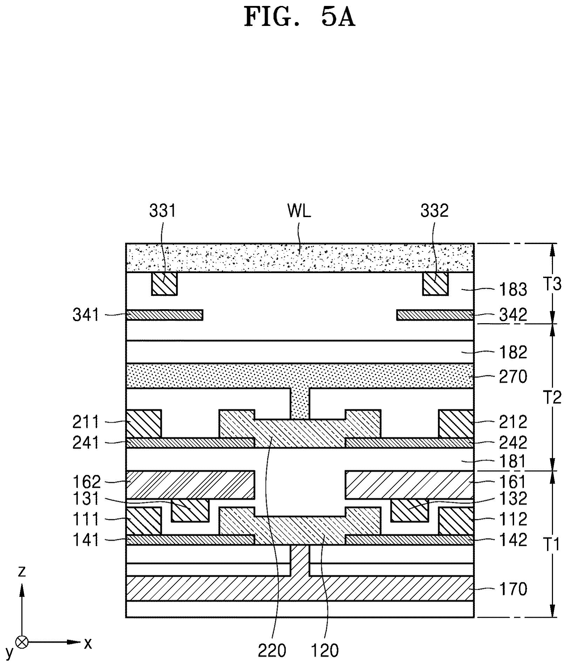

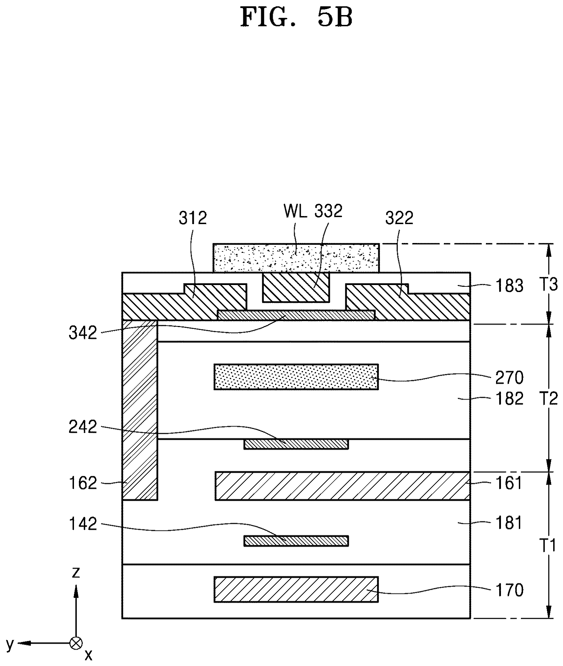

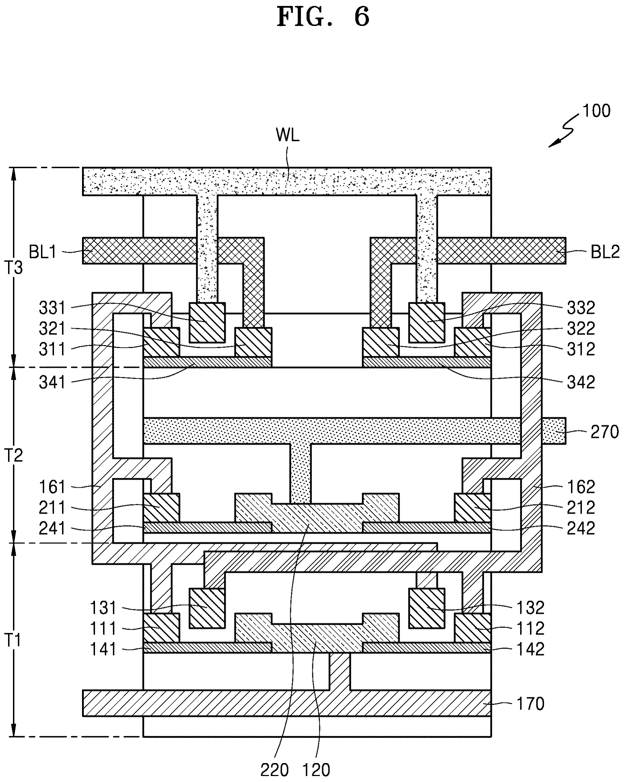

FIG. 3 is a plan view illustrating the SRAM device 100 according to an example embodiment. FIG. 4A is a plan view illustrating a first tier T1 of the SRAM device 100 of FIG. 3 according to an example embodiment. FIG. 4B is a plan view illustrating a second tier T2 of the SRAM device 100 of FIG. 3 according to an example embodiment. FIG. 4C is a plan view illustrating a third tier T3 of the SRAM device 100 of FIG. 3 according to an example embodiment. FIG. 5A is a cross-sectional view taken along line I-I' of FIG. 3. FIG. 5B is a cross-sectional view taken along line II-II' of FIG. 3. FIG. 6 is a view schematically illustrating a circuit configuration of the SRAM device 100 according to an example embodiment.

Referring to FIGS. 3 to 6, the first tier T1 may include a pair of transistors, that is, a first transistor and a second transistor, which are arranged apart from each other. Each of the first and second transistors may be a PMOS FET. For example, the first transistor may be the first pull-up transistor PUT1 (refer to FIG. 1), and the second transistor may be the second pull-up transistor PUT2 (refer to FIG. 1).

A first channel layer 141 forming the first transistor and a second channel layer 142 forming the second transistor are arranged apart from each other. Here, the first and second channel layers 141 and 142 may each extend in a first direction (x-axis direction). The first and second channel layers 141 and 142 may each include a 2D semiconductor material. The 2D semiconductor material may include, for example, a TMD, but is not limited thereto. Each of the first and second channel layers 141 and 142 may include, for example, a p-type 2D semiconductor material such as WSe₂. However, example embodiments are not limited thereto, and each of the first and second channel layers 141 and 142 may include a 2D semiconductor material doped with a p-type dopant. The first and second channel layers 141 and 142 may each have a monolayer or multilayer structure.

A first drain 111 may be provided on a side of the first channel layer 141, and a second drain 112 may be provided on a side of the second channel layer 142. A first common source 120 may be provided between the first channel layer 141 and the second channel layer 142. The first drain 111, the second drain 112, and the first common source 120 may each include a conductive material. A first common gate 131 (see FIG. 5A) may be provided above the first channel layer 141 between the first drain 111 and the first common source 120. A second common gate 132 (see FIG. 5A) may be provided above the second channel layer 142 between the second drain 112 and the first common source 120. Each of the first and second common gates 131 and 132 may extend in the first direction (x-axis direction). Each of the first and second common gates 131 and 132 may include, for example, a metal material or a conductive oxide material. For example, the metal material may include at least one selected from Au, Ti, TiN, TaN, W, Mo, WN, Pt, or Ni, and the conductive oxide material may include indium tin oxide (ITO), indium zinc oxide (IZO), or the like. However, these are only examples.

The first channel layer 141, and the first common source 120, the first drain 111, and the first common gate 131, which are provided on or above the first channel layer 141, may form the first transistor. The second channel layer 142, and the first common source 120, the second drain 112, and the second common gate 132, which are provided on or above the second channel layer 142, may form the second transistor. Here, the first common source 120 may be shared by the first transistor and the second transistor. That is, the first common source 120 may serve as a first source of the first transistor and a second source of the second transistor. The first common gate 131 may be shared by the first transistor and a third transistor disposed above the first transistor. That is, the first common gate 131 may serve as a first gate of the first transistor and a third gate of the third transistor. The second common gate 132 may be shared by the second transistor and a fourth transistor disposed above the second transistor. That is, the second common gate 132 may serve as a second gate of the second transistor and a fourth gate of the fourth transistor. A first insulating layer 181 (see FIG. 5A) is provided in the first tier T1 to cover the first and second transistors.

The first common source 120 may be connected to a supply voltage line 170. The supply voltage line 170 may extend in the first direction (x-axis direction) in a lower portion of the first tier T1. In a plan view, the supply voltage line 170 may overlap the first and second channel layers 141 and 142.

The first drain 111 of the first transistor and the second common gate 132 of the second transistor may be electrically connected to each other through a first metal line 161. The first metal line 161 may extend through a first via 191 formed in the first insulating layer 181 and may be electrically connected to a third drain 211 of the third transistor (described below). In addition, the first metal line 161 may extend through a second via 193 formed in the first insulating layer 181 and a second insulating layer 182 (see FIG. 5A), and may be electrically connected to a fifth drain 311 of a fifth transistor (described below).

The second drain 112 of the second transistor and the first common gate 131 of the first transistor may be electrically connected to each other through a second metal line 162. The second metal line 162 may extend through a third via 192 formed in the first insulating layer 181 and may be electrically connected to a fourth drain 212 of the fourth transistor (described below). In addition, the second metal line 162 may extend through a fourth via 194 formed in the first and second insulating layers 181 and 182, and may be electrically connected to a sixth drain 312 of a sixth transistor (described below).

The second tier T2 is provided above the first tier T1. The second tier T2 may include a pair of transistors arranged apart from each other, that is, the third transistor and the fourth transistor. Each of the third and fourth transistors may be an NMOS FET. For example, the third transistor may be the first pull-down transistor PDT1 (refer to FIG. 1), and the fourth transistor may be the second pull-down transistor PDT2 (refer to FIG. 1).

A third channel layer 241 forming the third transistor and a fourth channel layer 242 forming the fourth transistor are arranged apart from each other. Here, the third and fourth channel layers 241 and 242 may each extend in the first direction (x-axis direction). The third and fourth channel layers 241 and 242 may overlap the first and second channel layers 141 and 142 that are provided below the third and fourth channel layers 241 and 242, respectively. However, example embodiments are not limited thereto. Each of the third and fourth channel layers 241 and 242 may include a 2D semiconductor material. The 2D semiconductor material may include, for example, a TMD, but is not limited thereto. Each of the third and fourth channel layers 241 and 242 may have a monolayer or multilayer structure.

The third drain 211 may be provided on a side of the third channel layer 241, and the fourth drain 212 may be provided on a side of the fourth channel layer 242. A second common source 220 may be provided between the third channel layer 241 and the fourth channel layer 242. The third drain 211, the fourth drain 212, and the second common source 220 may each include a conductive material. The first common gate 131 described above may be provided under the third channel layer 241 between the third drain 211 and the second common source 220. The second common gate 132 described above may be provided under the fourth channel layer 242 between the fourth drain 212 and the second common source 220.

The third channel layer 241, and the second common source 220, the third drain 211, and the first common gate 131, which are provided on or under the third channel layer 241, may form the third transistor. The fourth channel layer 242, and the second common source 220, the fourth drain 212, and the second common gate 132, which are provided on or under the fourth channel layer 242, may form the fourth transistor. The second common source 220 may be shared by the third transistor and the fourth transistor. That is, the second common source 220 may function as a third source of the third transistor and a fourth source of the fourth transistor. As described above, the first common gate 131 may be shared by the first transistor and the third transistor, and the second common gate 132 may be shared by the second transistor and the fourth transistor. The second insulating layer 182 is provided in the second tier T2 to cover the third and fourth transistors. The third drain 211 of the third transistor is connected to the first metal line 161 through the first via 191 formed in the first insulating layer 181. In addition, the fourth drain 212 of the fourth transistor is connected to the second metal line 162 through the third via 192 formed in the first insulating layer 181.

The second common source 220 may be connected to a ground voltage line 270. The ground voltage line 270 may extend in the first direction (x-axis direction) in an upper portion of the second tier T2. In a plan view, the ground voltage line 270 may overlap the supply voltage line 170 provided below the ground voltage line 270.

The third tier T3 is provided above the second tier T2. The third tier T3 may include a pair of transistors arranged apart from each other, that is, the fifth transistor and the sixth transistor. Each of the fifth and sixth transistors may be an NMOS FET. For example, the fifth and sixth transistors may be the first and second access transistors XT1 and XT2, respectively.

A fifth channel layer 341 forming the fifth transistor and a sixth channel layer 342 forming the sixth transistor are arranged apart from each other. Here, the fifth and sixth channel layers 341 and 342 may each extend in a second direction (y-axis direction) crossing the first direction (x-axis direction). That is, the fifth channel layer 341 may cross (e.g., perpendicularly cross) the first and third channel layers 141 and 241 that are provided below the fifth channel layer 341. In addition, the sixth channel layer 342 may cross (e.g., perpendicularly cross) the second and fourth channel layers 142 and 242 that are provided below the sixth channel layer 342. Each of the fifth and sixth channel layers 341 and 342 may include a 2D semiconductor material. The 2D semiconductor material may include, for example, a TMD, but is not limited thereto. Each of the fifth and sixth channel layers 341 and 342 may have a monolayer or multilayer structure.

The fifth drain 311 and a fifth source 321 may be provided on opposite sides of the fifth channel layer 341, respectively, and the sixth drain 312 and a sixth source 322 may be provided on opposite sides of the sixth channel layer 342. The fifth drain 311, the fifth source 321, the sixth drain 312, and the sixth source 322 may each include a conductive material. A fifth gate 331 (see FIG. 5A) may be provided above the fifth channel layer 341 between the fifth drain 311 and the fifth source 321. A sixth gate 332 (see FIG. 5A) may be provided above the sixth channel layer 342 between the sixth drain 312 and the sixth source 322. The fifth gate 331 may cross the first common gate 131 provided below the fifth gate 331. The sixth gate 332 may cross the second common gate 132 provided below the sixth gate 332. Each of the fifth and sixth gates 331 and 332 may include, for example, a metal material or a conductive oxide material.

The fifth channel layer 341, and the fifth source 321, the fifth drain 311, and the fifth gate 331, which are provided on or above the fifth channel layer 341, may form the fifth transistor. In addition, the sixth channel layer 342, and the sixth source 322, the sixth drain 312, and the sixth gate 332, which are provided on or above the sixth channel layer 342, may form the sixth transistor. A third insulating layer 183 (see FIG. 5A) is provided in the third tier T3 to cover the fifth and sixth transistors. The fifth drain 311 of the fifth transistor is connected to the first metal line 161 through the second via 193 formed in the first and second insulating layers 181 and 182. In addition, the sixth drain 312 of the sixth transistor is connected to the second metal line 162 through the fourth via 194 formed in the first and second insulating layers 181 and 182.

The fifth source 321 may be connected to a first bit line BL1, and the sixth source 322 may be connected to a second bit line BL2. The first and second bit lines BL1 and BL2 may each extend in the second direction (y-axis direction). The fifth and sixth gates 331 and 332 may be connected to a word line WL. The word line WL may extend in the first direction (x-axis direction) in an upper portion of the third tier T3. In a plan view, the word line WL may overlap the supply voltage line 170 and the ground voltage line 270 that are provided below the word line WL.

FIG. 6 is a view schematically illustrating a circuit configuration of the SRAM device 100 according to an example embodiment. For ease of illustration, the fifth and sixth channel layers 341 and 342 provided in the third tier T3 are shown as extending in the same direction as the first to fourth channel layers 141, 142, 241, and 242 provided below the fifth and sixth channel layers 341 and 342.

Referring to FIG. 6, the first drain 111 of the first transistor and the second common gate 132 of the second transistor that are provided in the first tier T1 are electrically connected to each other through the first metal line 161. This first metal line 161 is connected to the third drain 211 of the third transistor provided in the second tier T2 and the fifth drain 311 of the fifth transistor provided in the third tier T3. Therefore, the fifth drain 311 of the fifth transistor, the third drain 211 of the third transistor, the first drain 111 of the first transistor, and the second common gate 132 of the second transistor are electrically connected to each other through the first metal line 161. The first metal line 161 may serve as wiring for forming the first node Q shown in the circuit diagram of FIG. 1.

The first common gate 131 of the first transistor and the second drain 112 of the second transistor provided in the first tier T1 are electrically connected to each other through the second metal line 162. The second metal line 162 is connected to the fourth drain 212 of the fourth transistor provided in the second tier T2 and the sixth drain 312 of the sixth transistor provided in the third tier T3. Therefore, the sixth drain 312 of the sixth transistor, the fourth drain 212 of the fourth transistor, the second drain 112 of the second transistor, and the first common gate 131 of the first transistor are electrically connected to each other through the second metal line 162. The second metal line 162 may serve as wiring for forming the second node Qb shown in the circuit diagram of FIG. 1.

The supply voltage line 170 electrically connected to the first common source 120 extends in the first direction in the lower portion of the first tier T1. The ground voltage line 270 electrically connected to the second common source 220 extends in the first direction in the upper portion of the second tier T2. In addition, the word line WL electrically connected to the fifth and sixth gates 331 and 332 extends in the first direction. Here, the supply voltage line 170, the ground voltage line 270, and the word line WL may overlap each other in a planar view. The first and second bit lines BL1 and BL2, electrically connected to the fifth and sixth sources 321 and 322, respectively, may be provided in the third tier T3. Although FIG. 6 shows that the first and second bit lines BL1 and BL2 extend in the first direction for ease of illustration, the first and second bit lines BL1 and BL2 may each extend in the second direction.

According to the example embodiments, each of the memory cells of the SRAM device 100 has a monolithic 3D stack structure in which three tiers each including a pair of transistors are provided. Metal lines are provided within the tiers to electrically connect transistors arranged in different tiers, and a gate of a transistor (e.g., an access transistor) provided in one tier and a gate of a transistor (e.g., a pull-up transistor or a pull-down transistor) provided in another tier are vertically arranged, thereby improving the area efficiency of each of the memory cells of the SRAM device 100. Furthermore, a supply voltage line, a ground voltage line, and a word line that are provided in different tiers, respectively, are arranged to overlap each other in a planar view, and thus, the area efficiency of each of the memory cells of the SRAM device 100 may be further improved. Moreover, transistors vertically arranged in different tiers are configured to share a single gate, thereby reducing the height of each of the memory cells of the SRAM device 100 and/or increasing the integration density of the SRAM device 100.

Hereinafter, first, second, and third tiers T1, T2, and T3 of each memory cell of an SRAM device will be described with reference to planar layouts and cross-sectional views according to other example embodiments. For example, first and second transistors disposed in the first tier T1 may be NMOS FETs, third and fourth transistors disposed in the second tier T2 may be NMOS FETs, and fifth and sixth transistors disposed in the third tier T3 may be PMOS FETs.

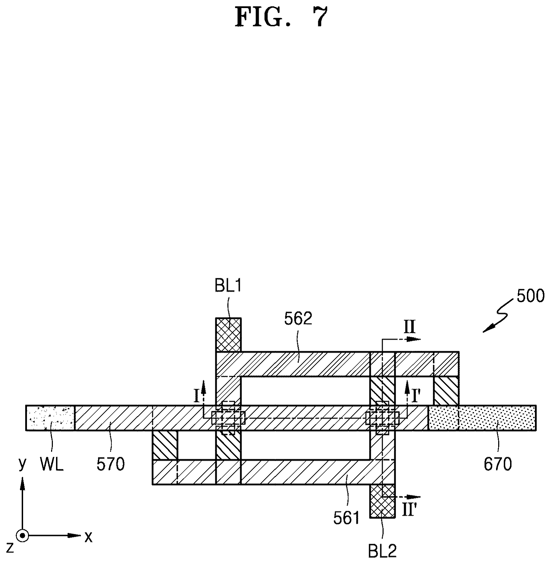

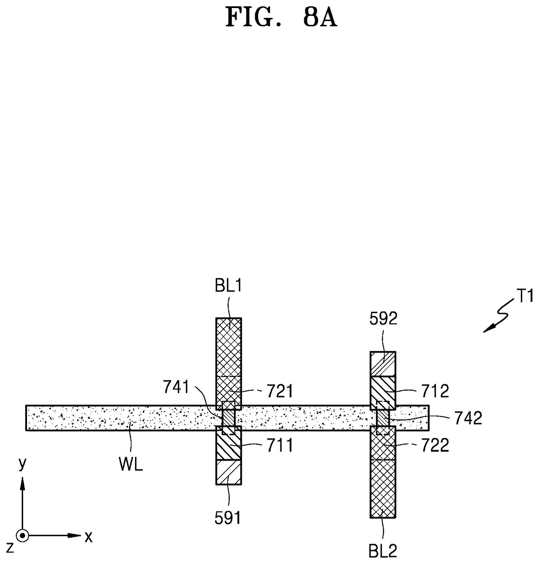

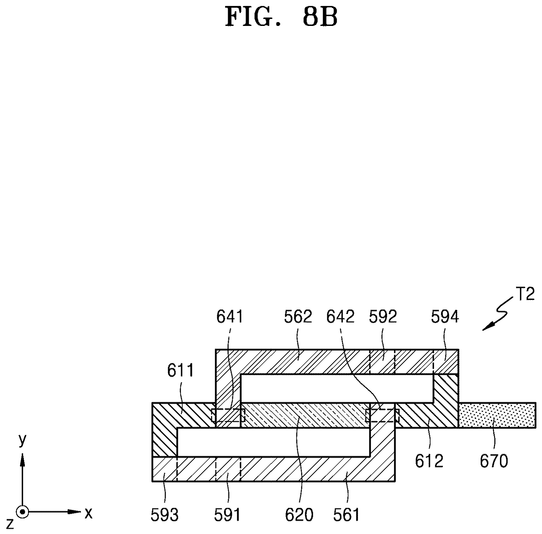

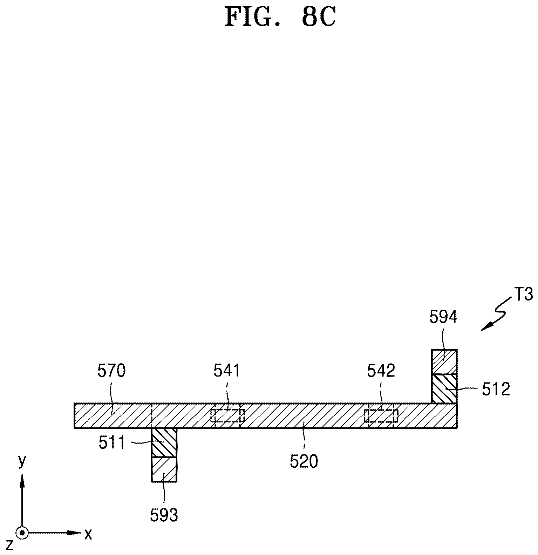

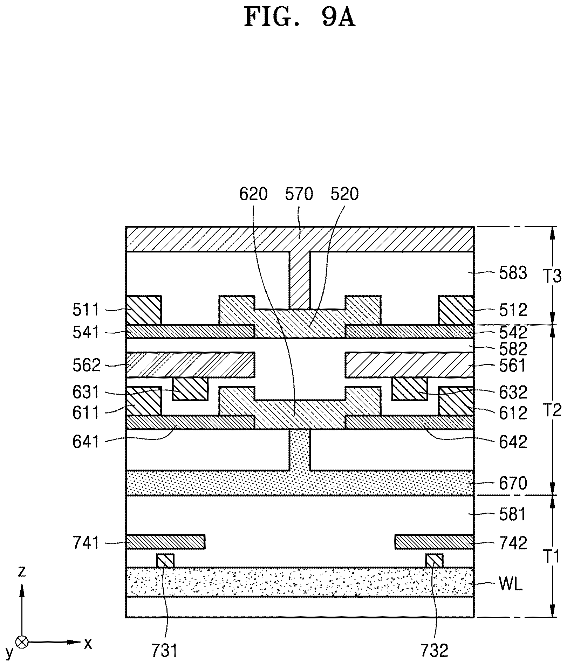

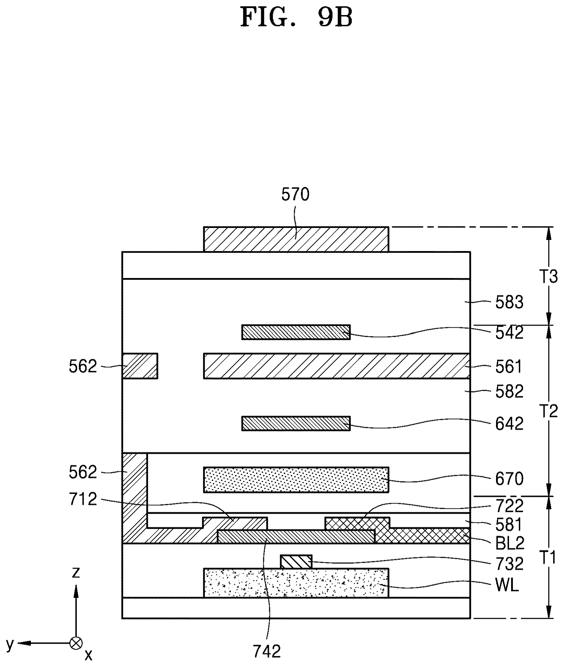

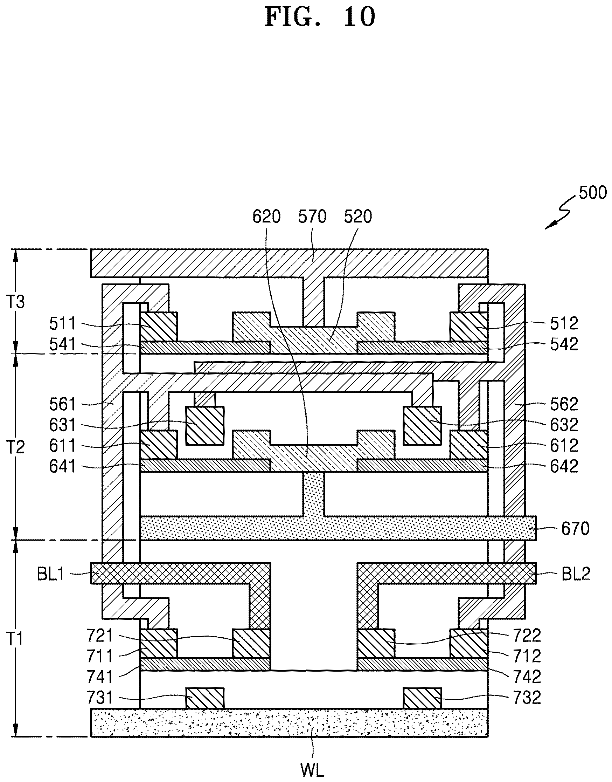

FIG. 7 is a plan view illustrating an SRAM device 500 according to another example embodiment. FIG. 8A is a plan view illustrating a first tier T1 of the SRAM device 500 of FIG. 7 according to an example embodiment. FIG. 8B is a plan view illustrating a second tier T2 of the SRAM device 500 of FIG. 7 according to an example embodiment. FIG. 8C is a plan view illustrating a third tier T3 of the SRAM device 500 of FIG. 7 according to an example embodiment. FIG. 9A is a cross-sectional view taken along line I-I' of FIG. 7. FIG. 9B is a cross-sectional view taken along line II-II' of FIG. 7. FIG. 10 is a view schematically illustrating a circuit configuration of the SRAM device 500 of FIG. 7 according to an example embodiment.

Referring to FIGS. 7 to 10, the first tier T1 may include a pair of transistors, that is, a first transistor and a second transistor, arranged apart from each other in a first direction (x-axis direction). Each of the first and second transistors may be an NMOS FET. For example, the first transistor may be the first access transistor XT1 (refer to FIG. 1), and the second transistor may be the second access transistor XT2 (refer to FIG. 1).

A first channel layer 741 forming the first transistor and a second channel layer 742 forming the second transistor are arranged apart from each other. Here, the first and second channel layers 741 and 742 may each extend in a second direction (y-axis direction). The first channel layer 741 may cross (e.g., perpendicularly cross) a third channel layer 641 and a fifth channel layer 541 that are provided above the first channel layer 741, and the second channel layer 742 may cross (e.g., perpendicularly cross) a fourth channel layer 642 and a sixth channel layer 542 that are provided above the second channel layer 742. Each of the first and second channel layers 741 and 742 may include a 2D semiconductor material. The 2D semiconductor material may include, for example, a TMD, but is not limited thereto. Each of the first and second channel layers 741 and 742 may have a monolayer or multilayer structure.

A first drain 711 and a first source 721 may be provided on opposite sides of the first channel layer 741, respectively, and a second drain 712 and a second source 722 may be provided on opposite sides of the second channel layer 742, respectively. The first drain 711, the first source 721, the second drain 712, and the second source 722 may each include a conductive material. A first gate 731 may be provided below the first channel layer 741 between the first drain 711 and the first source 721. A second gate 732 may be provided below the second channel layer 742 between the second drain 712 and the second source 722. The first gate 731 may cross a first common gate 631 provided above the first gate 731. The second gate 732 may cross a second common gate 632 provided above the second gate 732. Each of the first and second gates 731 and 732 may include, for example, a metal material or a conductive oxide material.

The first channel layer 741, and the first source 721, the first drain 711, and the first gate 731, which are provided on or below the first channel layer 741, may form the first transistor. The second channel layer 742, and the second source 722, the second drain 712, and the second gate 732, which are provided on or below the second channel layer 742, may form the second transistor. A first insulating layer 581 is provided in the first tier T1 to cover the first and second transistors.

The first source 721 may be connected to a first bit line BL1, and the second source 722 may be connected to a second bit line BL2. The first and second bit lines BL1 and BL2 may each extend in the second direction (y-axis direction). The first and second gates 731 and 732 may be connected to a word line WL. The word line WL may extend in the first direction (x-axis direction) in a lower portion of the first tier T1.

The second tier T2 is provided above the first tier T1. The second tier T2 may include a pair of transistors, that is, a third transistor and a fourth transistor, arranged apart from each other. Each of the third and fourth transistors may be an NMOS FET. For example, the third transistor may be the first pull-down transistor PDT1 (refer to FIG. 1), and the fourth transistor may be the second pull-down transistor PDT2 (refer to FIG. 1).

The third channel layer 641 forming the third transistor and the fourth channel layer 642 forming the fourth transistor are arranged apart from each other. Here, the third and fourth channel layers 641 and 642 may each extend in the first direction (x-axis direction). The third channel layer 641 may cross (e.g., perpendicularly cross) the first channel layer 741 provided below the third channel layer 641, and the fourth channel layer 642 may cross (e.g., perpendicularly cross) the second channel layer 742 provided below the fourth channel layer 642. Each of the third and fourth channel layers 641 and 642 may include a 2D semiconductor material. The 2D semiconductor material may include, for example, a TMD, but is not limited thereto. Each of the third and fourth channel layers 641 and 642 may have a monolayer or multilayer structure.

A third drain 611 may be provided on a side of the third channel layer 641, and a fourth drain 612 may be provided on a side of the fourth channel layer 642. In addition, a first common source 620 may be provided between the third channel layer 641 and the fourth channel layer 642. The third drain 611, the fourth drain 612, and the first common source 620 may each include a conductive material. The first common gate 631 may be provided above the third channel layer 641 between the third drain 611 and the first common source 620. The second common gate 632 may be provided above the fourth channel layer 642 between the fourth drain 612 and the first common source 620. Each of the first and second common gates 631 and 632 may include, for example, a metal material or a conductive oxide material.

The third channel layer 641, and the first common source 620, the third drain 611, and the first common gate 631, which are provided on or above the third channel layer 641, may form the third transistor. In addition, the fourth channel layer 642, and the first common source 620, the fourth drain 612, and the second common gate 632, which are provided on or above the fourth channel layer 642, may form the fourth transistor. The first common source 620 may be shared by the third transistor and the fourth transistor. That is, the first common source 620 may serve as a third source of the third transistor and a fourth source of the fourth transistor. The first common gate 631 may be shared by the third transistor and a fifth transistor disposed above the third transistor, and the second common gate 632 may be shared by the fourth transistor and a sixth transistor disposed above the fourth transistor. A second insulating layer 582 is provided in the second tier T2 to cover the third and fourth transistors.

The first common source 620 may be connected to a ground voltage line 670. This ground voltage line 670 may extend in the first direction (x-axis direction) and may be in a lower portion of the second tier T2. In a planar view, the ground voltage line 670 may overlap the word line WL provided below the ground voltage line 670.

The third drain 611 of the third transistor and the second common gate 632 of the fourth transistor may be electrically connected to each other through a first metal line 561. The first metal line 561 may extend through a first via 591 formed in the first insulating layer 581 and may be electrically connected to the first drain 711 of the first transistor. In addition, the first metal line 561 may extend through a second via 593 formed in the second insulating layer 582 and may be electrically connected to a fifth drain 511 of the fifth transistor (described later).

The fourth drain 612 of the fourth transistor and the first common gate 631 of the third transistor may be electrically connected to each other through a second metal line 562. The second metal line 562 may extend through a third via 592 formed in the first insulating layer 581 and may be electrically connected to the second drain 712 of the second transistor. In addition, the second metal line 562 may extend through a fourth via 594 formed in the second insulating layer 582 and may be electrically connected to a sixth drain 512 of the sixth transistor (described later).

The third tier T3 is provided above the second tier T2. The third tier T3 may include a pair of transistors, that is, the fifth transistor and the sixth transistor, arranged apart from each other. Each of the fifth and sixth transistors may be a PMOS FET. For example, the fifth transistor may be the first pull-up transistor PUT1 (refer to FIG. 1), and the sixth transistor may be the second pull-up transistor PUT2 (refer to FIG. 1).

The fifth channel layer 541 forming the fifth transistor and the sixth channel layer 542 forming the sixth transistor are arranged apart from each other. Here, the fifth and sixth channel layers 541 and 542 may each extend in the first direction (x-axis direction). The fifth and sixth channel layers 541 and 542 may overlap the third and fourth channel layers 641 and 642 provided in the second tier T2, respectively. The fifth and sixth channel layers 541 and 542 may cross (e.g., perpendicularly cross) the first and second channel layers 741 and 742, respectively, which are provided in the first tier T1. Each of the fifth and sixth channel layers 541 and 542 may include a 2D semiconductor material. The 2D semiconductor material may include, for example, a TMD, but is not limited thereto. Each of the fifth and sixth channel layers 541 and 542 may have a monolayer or multilayer structure.

The fifth drain 511 may be provided on a side of the fifth channel layer 541, and the sixth drain 512 may be provided on a side of the sixth channel layer 542. In addition, a second common source 520 may be provided between the fifth channel layer 541 and the sixth channel layer 542. The fifth drain 511, the sixth drain 512, and the second common source 520 may each include a conductive material. The first common gate 631 described above may be provided below the fifth channel layer 541 between the fifth drain 511 and the second common source 520. The second common gate 632 described above may be provided below the sixth channel layer 542 between the sixth drain 512 and the second common source 520.

The fifth channel layer 541, and the second common source 520, the fifth drain 511, and the first common gate 631, which are provided on or below the fifth channel layer 541, may form the fifth transistor. In addition, the sixth channel layer 542, and the second common source 520, the sixth drain 512, and the second common gate 632, which are provided on or below the sixth channel layer 542, may form the sixth transistor. The second common source 520 may be shared by the fifth and sixth transistors. That is, the second common source 520 may function as a fifth source of the fifth transistor and a sixth source of the sixth transistor. As described above, the first common gate 631 may be shared by the third and fifth transistors, and the second common gate 632 may be shared by the fourth and sixth transistors. A third insulating layer 583 is provided in the third tier T3 to cover the fifth and sixth transistors.

The second common source 520 may be connected to a supply voltage line 570. The supply voltage line 570 may extend in the first direction (x-axis direction) in an upper portion of the third tier T3. In a planar view, the supply voltage line 570 may overlap the ground voltage line 670 and the word line WL that are provided below the supply voltage line 570.

FIG. 10 is a view schematically illustrating a circuit configuration of the SRAM device 500 of FIG. 7 (as well as FIGS. 8A-9B) according to another example embodiment. For ease of illustration, the first and second channel layers 741 and 742 provided in the first tier T1 are shown as extending in the same direction as the third to sixth channel layers 641, 642, 541, and 542 provided above the fifth and sixth channel layers 741 and 742.

Referring to FIG. 10, the third drain 611 of the third transistor and the second common gate 632 of the fourth transistor that are provided in the second tier T2 are electrically connected to each other through the first metal line 561. The first metal line 561 is connected to the fifth drain 511 of the fifth transistor provided in the third tier T3 and the first drain 711 of the first transistor provided in the first tier T1. Therefore, the fifth drain 511 of the fifth transistor, the third drain 611 of the third transistor, the second common gate 632 of the fourth transistor, and the first drain 711 of the first transistor are electrically connected to each other through the first metal line 561.

The first common gate 631 of the third transistor and the fourth drain 612 of the fourth transistor that are provided in the second tier T2 are electrically connected to each other through the second metal line 562. The second metal line 562 is connected to the sixth drain 512 of the sixth transistor provided in the third tier T3 and the second drain 712 of the second transistor provided in the first tier T1. Therefore, the sixth drain 512 of the sixth transistor, the first common gate 631 of the third transistor, the fourth drain 612 of the fourth transistor, and the second drain 712 of the second transistor are electrically connected to each other through the second metal line 562.

The ground voltage line 670 electrically connected to the first common source 620 extends in the first direction in the lower portion of the second tier T2, and the supply voltage line 570 electrically connected to the second common source 520 extends in the first direction in the upper portion of the third tier T3. In addition, the word line WL electrically connected to the first and second gates 731 and 732 extends in the first direction in a lower portion of the first tier T1. Here, the supply voltage line 570, the ground voltage line 670, and the word line WL may overlap each other in a planar view. The first and second bit lines BL1 and BL2 that are electrically connected to the first and second sources 721 and 722, respectively, may be provided in the first tier T1. Although FIG. 10 shows that the first and second bit lines BL1 and BL2 extend in the first direction for ease of illustration, the first and second bit lines BL1 and BL2 may each extend in the second direction.

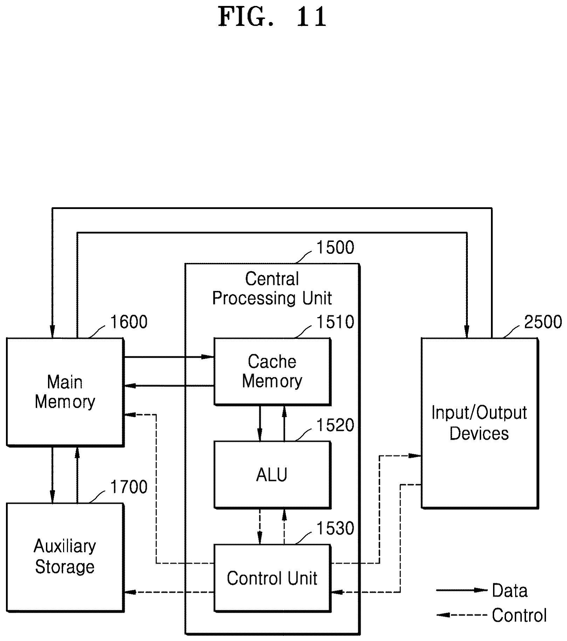

The SRAM devices 100 and 500 having a monolithic 3D stack structure described above in the example embodiments may be applied to various electronic apparatuses. FIG. 11 is a conceptual view schematically illustrating a device architecture applicable to an electronic apparatus according to an example embodiment.

Referring to FIG. 11, a cache memory 1510, an arithmetic logic unit (ALU) 1520, and a control unit 1530 may form a central processing unit (CPU) 1500, and the cache memory 1510 may include one of the SRAM devices 100 and 500 described above. A main memory 1600 and an auxiliary storage 1700 may also be provided separately from the CPU 1500. In some cases, the device architecture may be implemented in the form in which unit computing devices and unit memory devices are adjacent to each other on one chip without any distinction between sub-units. Furthermore, in some cases, the device architecture may include input/output devices 2500. While some example embodiments have been described above, these are merely illustrative, and various modifications may be made therein by those of ordinary skill in the art.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

According to the above example embodiments, each of the memory cells of the SRAM devices has a monolithic 3D stack structure in which three tiers each including a pair of transistors are provided. Here, metal lines are provided within the tiers to electrically connect transistors arranged in different tiers, and a gate of a transistor (e.g., an access transistor) provided in one tier and a gate of a transistor (e.g., a pull-up transistor or a pull-down transistor) provided in another tier are vertically arranged or aligned, thereby improving the area efficiency of each of the memory cells of the SRAM devices. Furthermore, a supply voltage line, a ground voltage line, and a word line that are provided in different tiers are arranged to overlap each other in a planar view, and thus, the area efficiency of each of the memory cells of the SRAM devices may be further improved. Moreover, transistors vertically arranged in different tiers are configured to share a single gate, thereby reducing the height of each of the memory cells of the SRAM devices and/or increasing the integration density of the SRAM devices.

It should be understood that some example embodiments described herein should be considered in a descriptive sense only and not for purposes of limitation. Descriptions of features or aspects within each example embodiment should typically be considered as available for other similar features or aspects in other example embodiments. While one or more example embodiments have been described with reference to the figures, it will be understood by those of ordinary skill in the art that various changes in form and details may be made therein without departing from the scope as defined by the following claims.

## Claims

1. A static random-access memory, SRAM, device comprising:
a first tier comprising a first transistor and a second transistor;
a second tier on the first tier, the second tier comprising a third transistor and a fourth transistor; and
a third tier on the second tier, the third tier comprising a fifth transistor and a sixth transistor,
wherein each of the first to sixth transistors comprises a channel layer comprising a 2D semiconductor material,
the third transistor shares a gate of the first transistor, the fourth transistor shares a gate of the second transistor,
a gate of the fifth transistor crosses the gate of the first transistor, and a gate of the sixth transistor crosses the gate of the second transistor.

2. The SRAM device of claim 1, wherein
the first and second transistors share a first common source, and
a supply voltage line is in a lower portion of the first tier and is connected to the first common source.

3. The SRAM device of claim 2, wherein
the third and fourth transistors share a second common source, and
a ground voltage line is provided in an upper portion of the second tier and is connected to the second common source.

4. The SRAM device of claim 3, wherein a word line is in an upper portion of the third tier and is connected to the gates of the fifth and sixth transistors,

5. The SRAM device of claim 4, wherein the supply voltage line, the ground voltage line, and the word line overlap each other in a plan view.

6. The SRAM device of one of claims 1 to 5, wherein a drain of the first transistor, the gate of the second transistor, a drain of the third transistor, and a drain of the fifth transistor are electrically connected to each other through a first metal line.

7. The SRAM device of one of claims 1 to 5, wherein a drain of the second transistor, the gate of the first transistor, a drain of the fourth transistor, and a drain of the sixth transistor are electrically connected to each other through a second metal line.

8. The SRAM device of one of claims 1 to 7, wherein each of the first and second transistors comprises a p-channel metal-oxide-semiconductor, PMOS, field-effect transistor, FET, and each of the third, fourth, fifth, and sixth transistors comprises an n-channel metal-oxide-semiconductor, NMOS, FET,
wherein the first and third transistors preferably configure a first complementary metal-oxide-semiconductor, CMOS, inverter, and the second and fourth transistors preferably configure a second CMOS inverter, and
wherein each of the fifth and sixth transistors preferably comprises an access transistor.

9. A static random-access memory, SRAM, device comprising:
a first tier comprising a first transistor and a second transistor;
a second tier on the first tier, the second tier comprising a third transistor and a fourth transistor; and
a third tier on the second tier, the third tier comprising a fifth transistor and a sixth transistor,
wherein each of the first to sixth transistors comprises a channel layer comprising a 2D semiconductor material,
the fifth transistor shares a gate of the third transistor, the sixth transistor shares a gate of the fourth transistor,
a gate of the first transistor crosses the gate of the third transistor, and a gate of the second transistor crosses the gate of the fourth transistor.

10. The SRAM device of claim 9, wherein a word line is in a lower portion of the first tier and is connected to the gate of the first transistor and the gate of the second transistor.

11. The SRAM device of claim 10, wherein the third and fourth transistors share a first common source, and a ground voltage line is in a lower portion of the second tier and is connected to the first common source,
wherein the fifth and sixth transistors preferably share a second common source, and a supply voltage line is preferably in an upper portion of the third tier and is preferably connected to the second common source, and
wherein the word line, the ground voltage line, and the supply voltage line preferably overlap each other in a plan view.

12. The SRAM device of one of claims 9 to 11, wherein a drain of the first transistor, a drain of the third transistor, the gate of the fourth transistor, and a drain of the fifth transistor are electrically connected to each other through a first metal line, or
wherein a drain of the second transistor, the gate of the third transistor, a drain of the fourth transistor, and a drain of the sixth transistor are electrically connected to each other through a second metal line.

13. The SRAM device of one of claims 9 to 12, wherein
each of the first, second, third, and fourth transistors comprises an n-channel metal-oxide-semiconductor, NMOS, field-effect transistor, FET, and
each of the fifth and sixth transistors comprises a p-channel metal-oxide-semiconductor, PMOS, FET.

14. An electronic apparatus comprising a static random-access memory, SRAM, device according to one of claims 1 to 13.

15. The electronic apparatus of claim 14, wherein a supply voltage line in the first tier, a ground voltage line in the second tier, and a word line in the third tier overlap each other in a plan view.
